# EUROPÄISCHE PATENTSCHRIFT

(11) **EP 1 989 731 B1**
(45) Veröffentlichungstag und Bekanntmachung des Hinweises auf die Patenterteilung: **06.02.2019**
(21) Anmeldenummer: 06841568.6
(22) Anmeldetag: 21.12.2006
(51) Int. Cl.: H01L 21/60, H01L 23/538, H01L 23/66, H01L 23/485, H01L 21/58

(54) **VERFAHREN ZUM HERSTELLEN UND PLANAREN KONTAKTIEREN EINER ELEKTRONISCHEN VORRICHTUNG**
METHOD FOR MANUFACTURING AND MAKING PLANAR CONTACT WITH AN ELECTRONIC APPARATUS
PROCÉDÉ DE FABRICATION ET DE MISE EN CONTACT PLANAIRE D'UN DISPOSITIF ÉLECTRONIQUE

(30) Priorität: 02.03.2006 DE 102006009723
(43) Veröffentlichungstag der Anmeldung: 12.11.2008
(73) Patentinhaber: Siemens Aktiengesellschaft, 80333 München (DE)
(72) Erfinder: SCHIMETTA, Gernot, 81541 München (DE); TSCHERNITZ, Maximilian, 85354 Freising (DE)
(86) Internationale Anmeldenummer: PCT/EP2006/070110
(87) Internationale Veröffentlichungsnummer: WO 2007/098820

(56) Entgegenhaltungen:
- EP-A- 1 304 742
- EP-A- 1 381 080
- EP-A- 1 755 162
- EP-A1- 0 434 311
- US-A- 5 198 385
- US-A1- 2004 152 242
- US-B1- 6 229 203
- US-B1- 6 400 573

## Beschreibung

Die vorliegende Erfindung betrifft ein Verfahren zum Herstellen und planaren Kontaktieren einer elektronischen Vorrichtung, insbesondere eines Hochfrequenzmoduls.

Die Massenfertigung von Radarmodulen basierend auf Nacktchipverarbeitung, insbesondere für eine Betriebsfrequenz von 77 GHz, verwendet herkömmlicher Weise so genannte Drahtbondverfahren. Betriebsfrequenzen im Bereich von 77 GHz werden insbesondere für ein so genanntes Long Range Radar beispielsweise als Basis für longitudinale Fahrzeugsteuerung verwendet. Das herkömmliche Drahtbonden stellt lediglich eine geringe Prozesssicherheit der verwendeten Chipkontaktiertechnik bereit. Das herkömmliche Drahtbonden ist sehr kostenwirksam. Bei dem nachteiliger Weise seriellen Drahtbondprozess sind Drahtbonds beispielsweise von 0,3 mm bis 0,4 mm Länge mit einer Genauigkeit beispielsweise von etwa +/- 5 % herzustellen. Aufgrund der zahlreichen Kontaktierstellen in einem herkömmlichen Radarmodul sind die Stückkosten sehr hoch. Deshalb weist die so genannte 77 beziehungsweise 79 GHz Radartechnologie trotz einiger Systemvorteile gegenüber Konkurrenztechnologien, wie beispielsweise LIDAR (dies beruht auf einem Abtasten der Umgebung mittels Laserstrahl) Nachteile auf. Die Kosten für die Herstellung (Assembly) bewirken den Großteil der Systemkosten. Es erscheint insbesondere für Europa ein Wechsel von der 24 GHz-Technologie auf eine 79 GHz-Technologie als notwendig. Auf diese Weise ergibt sich ein Bedarf an kostengünstigen Packaging-Lösungen. Monolithische Systeme, bei denen das gesamte Radar-Frontend auf einem Chip vereinigt ist, erscheinen ebenso in naher Zukunft als nicht verfügbar. Die Verwendung der so genannten Flip-Chip-Technik erscheint aufgrund der Anregung von Schwingungsmoden zwischen Chip und Substrat und einer schlechten Wärmespreizung als nachteilig. Eine Verwendung der herkömmlichen Surface Mount Technology (SMT) bei 24 GHz Radarmodulen ist aufgrund der verwendeten hohen Frequenzen ebenso nachteilig. Gemäß dem Stand der Technik werden gedünnte HF-Chips (Hochfrequenz-Chips) mittels eines elektrisch leitfähigen Klebstoffs mit hoher Genauigkeit auf eine Trägerplatte geklebt. Zu diesem Zweck ist aus der die Platte ganzflächig bedeckenden Isolationsfolie per Laser eine Öffnung beziehungsweise ein Fenster für den Chip geschnitten. Dieses Fenster ist geringfügig größer als der Chip, so dass sich ein schmaler umlaufender Spalt ergibt, der umlaufende Luftspalt sorgt für eine Potentialtrennung zwischen Chipoberseite und Chipunterseite (Masse) ohne parasitäre Kapazitäten. Chip und Isolationsfolie besitzen annähernd gleiche Dicke. Auf der Isolationsfolie befinden sich alle HF- (und NF-) Signalleitungen, und ebenso die Versorgungsleitungen. Gemäß dem herkömmlich verwendeten Drahtbondvorgang werden Chippad und HF-Leitung miteinander verbunden. Direkte Chip-to-Chip Verbindungen können unter Umständen ebenfalls realisiert werden.

Gemäß dem Stand der Technik wird eine Isolierfolie auf eine Trägerplatte aufgebracht. Es wird mindestens ein Fenster für mindestens einen Chip in die Isolationsfolie gelasert. Ein gedünnter HF-Chip wird mittels eines Klebers in dem Fenster auf die Trägerplatte geklebt. Gemäß dem herkömmlichen Verfahren werden Kontaktflächen des Chips und elektrische Leitungen auf der Isolierfolie mittels Drahtbonden kontaktiert. Das herkömmliche Drahtbonden muss seriell ausgeführt werden und ist auf diese Weise sehr kostenwirksam und sehr langsam.

US 6 400 573 B1 zeigt ein alternatives Verfahren, in dem eine zweite elektrisch isolierende Schicht auf dem Bauelement, auf der ersten elektrisch isolierenden Schicht und über einem Abstandsbereich zwischen dem Bauelement und der ersten Schicht aufgebracht wird, die Kontaktflächen freigelegt werden und Verbindungsleitungen auf der zweiten elektrisch isolierenden Schicht und in Kontakt mit den Kontaktflächen aufgebracht werden.

Es ist Aufgabe der vorliegenden Erfindung elektronische Vorrichtungen, insbesondere Hochfrequenzmodule, auf kostengünstige Weise herzustellen, wobei elektronische Bauelemente, wie dies beispielsweise Halbleiterchips und passive Bauteile (Kondensatoren, Widerstände, Induktivitäten) sind, zuverlässig elektrisch kontaktiert werden und eine wirksame Potentialtrennung zwischen Ober- und Unterseite der elektronischen Bauelemente erzeugt wird.

Die Aufgabe wird durch ein Verfahren gemäß dem Hauptanspruch gelöst.

Das Verfahren verwendet Substrate, die Kupfer und/oder Aluminium aufweisen. Ebenso können so genannte LTCC (Low Temperature Cofired Ceramic) - Substrate verwendet werden. Das Öffnen mindestens eines Fensters für mindestens ein elektronisches Bauelement, wie es beispielsweise ein (Halbleiter-)chip ist, in der ersten Schicht wird beispielsweise mittels Laser ausgeführt. In dieser Beschreibung wird im Folgenden "Halbleiterchip" oder "Chip" geschrieben, die als Beispiele für allgemein "elektronische _Bauelemente" anzusehen sind. Ein Fixieren eines Halbleiterchips innerhalb einer Öffnung beziehungsweise eines Fensters kann mittels eines Klebers ausgeführt werden. Die zweite Schicht dient insbesondere der elektrischen Isolierung. Die zweite Schicht überbrückt insbesondere den Abstandsbereich.

Es werden die herkömmlichen extrem kurzen Bonddrähte durch beispielsweise galvanisch, mittels Dampfen oder Sputtern abgeschiedene Verbindungen ersetzt. Aufbringen von elektrisch leitendem Material kann galvanisch, mittels Dampfen oder Sputtern erfolgen. Als Träger von Brücken über die die Halbleiterchips oder Chips umlaufenden Luftspalte, beziehungsweise zur Isolation kann eine Kunststofffolie, insbesondere eine Polymerfolie, über den Halbleiterchip gespannt werden. Die Kontaktstellen des Halbleiterchips können mittels Photolithographie oder mittels eines Laserprozesses geöffnet werden. Gemäß den beanspruchten Verfahren können elektronische Vorrichtungen, insbesondere Hochfrequenzmodule kostengünstig in Massenfertigungen erzeugt werden. Es werden parallele, stabile Prozesse zur Halbleiterchipkontaktierung geschaffen. Auf diese Weise werden Assembly-Kosten
beziehungsweise Zusammenbaukosten wirksam reduziert. Ebenso vorteilhaft ist es, dass die Anzahl der Kontakte auf einem Modul keinen Einfluss auf die Kontaktierkosten hat. Diese ist lediglich von der Fläche eines Moduls abhängig. Es wird besonders vorteilhaft aufgrund der präziseren und kürzeren Abstände zwischen Halbleiterchip und Hochfrequenzleitungen auf dem Substrat eine höhere Signalintegrität bereitgestellt. Gemäß dem vorgeschlagenen Verfahren ist ein Kontaktieren von Bauteilen mit unterschiedlicher Höhe, beispielsweise von Kondensatoren und Halbleiterchips, ebenso möglich. Ebenso kann mittels der zweiten Schicht ein physikalischer und/oder chemischer Schutz für den Halbleiterchip bereitgestellt werden. Weitere Vorteile sind:
Das Öffnen der zweiten Schicht ist an jedem Punkt möglich. Ausgenommen ist lediglich der umlaufende Spalt um den Halbleiterchip. Auf diese Weise entfällt die Notwendigkeit der Positionierung von Bond-Kontaktflächen am Halbleiterchiprand. Es ist der Aufbau von sehr kompakten und auf diese Weise kostengünstigen Hochfrequenzmodulen möglich.

Eine physikalische Grenze stellt lediglich die gegenseitige Beeinflussung von Hochfrequenzleitungen dar. Es können elektronische Vorrichtungen hergestellt werden, die beispielsweise die Integration von Antennen ermöglichen.

Ebenso ist eine kostenwirksame Einkapselung der gesamten elektronischen Vorrichtung, insbesondere eines Hochfrequenzmoduls, möglich. Es können Hochfrequenzmodule mit erheblich reduzierten Abmessungen erzeugt werden. Auf diese Weise kann beispielsweise ein so genanntes Automotive Radar einfacher in ein Kraftfahrzeug integriert werden. Eine Integration ist beispielsweise in eine KFZ-Stoßstange möglich. Zudem können neue Einbauorte verwendet werden. Zudem ist es möglich, erfindungsgemäße Verfahren mit der so genannten Surface Mounted Device (SMD-) Technologie, insbesondere im Niederfrequenzteil, zu verwenden. Es können kleinere Bauteile unter der zweiten Schicht integriert werden, größere Bauelemente können im Anschluss daran montiert werden.

Gemäß einer vorteilhaften Ausgestaltung ist die zweite Schicht eine Kunststofffolie, die ganzflächig, beispielsweise mittels Tiefziehen oder Auflaminieren, aufgebracht wird. Diese Kunststofffolie wird über der mindestens einen Kontaktfläche des mindestens einen Halbleiterchips und der mindestens einen Kontaktstelle der mindestens einen elektrischen Leitung geöffnet. Das Öffnen kann beispielsweise mittels Laserablation (ein flächiges Öffnen) ausgeführt werden. Es wird hiermit auf die WO 03/030247 Bezug genommen, die ein Verfahren zum planaren beziehungsweise flächigen Kontaktieren elektrischer Kontaktflächen eines Substrats und eine Vorrichtung aus einem Substrat mit elektrischen Kontaktflächen offenbart. Gemäß diesem Verfahren wird eine Folie aus elektrisch isolierendem Kunststoffmaterial auf die Oberfläche eines Substrats unter Vakuum derart auflaminiert, dass die Folie die Oberfläche mit der oder den Kontaktflächen eng anliegend bedeckt und auf dieser Oberfläche haftet. Ein Freilegen jeder zu kontaktierenden Kontaktfläche auf der Oberfläche erfolgt mittels Öffnen jeweiliger Fenster in der Folie. Abschließend erfolgt ein flächiges Kontaktieren jeder freigelegten Kontaktfläche mit einer Schicht aus elektrisch leitendem Material.

Gemäß einem weiteren Ausführungsbeispiel ist die zweite Schicht eine fotostrukturierte Schicht. Dabei wird die zweite Schicht als elektrisch isolierende Folie, insbesondere Kunststofffolie oder als Lack erzeugt. Mittels Photolithographie wird eine fotostrukturierbare Schicht, eine Kunststofffolie oder ein Lack, belichtet und entwickelt. Die fotostrukturierte Schicht ist derart erzeugt, dass Kontaktflächen und Kontaktstellen unbedeckt bleiben.

Die zweite Schicht wird erfindungsgemäß wieder entfernt. Bei Verwendung einer Kunststofffolie beziehungsweise einer Folie aus elektrisch isolierendem Kunststoffmaterial kann die zweite Schicht mittels Laser entfernt werden. Bei Verwendung einer fotostrukturierten Schicht ist die Entfernung der zweiten Schicht auf besonders einfache und kostengünstige Weise mittels Verwendung einer chemischen Lösung ausführbar. Ist die zweite Schicht eine Folie aus elektrisch isolierendem Kunststoffmaterial, so kann diese Folie auf dem Halbleiterchip, bei entsprechender Halbleiterchippassivierung, auf der gesamten elektrisch aktiven Fläche mittels Laser abgetragen werden, falls dies entsprechend den Hochfrequenzbedingungen vorteilhafter ist. Es verbleibt lediglich ein Folienrahmen oder optional eine dünne Restschicht der Folie im elektrisch aktiven Halbleiterchipbereich.

Gemäß einer weiteren vorteilhaften Ausgestaltung umfasst ein galvanisches Abscheiden folgende Schritte. Ein ganzflächiges Aufbringen einer Galvanik-Grundmetallisierung kann mittels Sputtern(Kathodenzerstäubung) oder Aufdampfen ausgeführt werden. Dabei kann eine Grundmetallisierung eine Titanschicht sein, auf der eine Wolfram-Titan-Schicht angeordnet wird, auf der wiederum eine Kupferschicht aufgebracht wird. Dabei stellt die Wolfram-Titan-Schicht eine Diffusionsbarriere bereit. Bei einem herkömmlichen Sputtern wird in einer Vakuumkammer zwischen zwei plattenförmigen Elektroden angeordnetes Substrat mit beispielsweise Kupfer-Ionen beschossen. Gemäß einem zweiten Schritt erfolgt ein Aufbringen einer fotostrukturierten Abdeckschicht. Diese Abdeckschicht kann eine Folie oder ebenso eine Lackschicht sein. Eine Fotostrukturierung erfolgt mittels Photolithographie und den Verfahrensschritten Aufsprühen der Abdeckschicht, Belichten und Entwickeln der Abdeckschicht. Von der erzeugten Abdeckschicht unbedeckte, galvanisierbare Bereiche entsprechen elektrischen Verbindungsleitungen, Kontaktflächen und Kontaktstellen. Es folgt ein Galvanisieren der unbedeckten Bereiche. Hierbei wird die bisher erzeugte Anordnung in einen Elektrolyten eingetaucht. Dabei kann beispielsweise eine Schichtfolge Kupfer, Nickel und Gold erzeugt werden, wobei die Goldschicht die obere und die Kupferschicht die auf der Galvanik-Grundmetallisierung direkt aufgebrachte Schicht ist. Die Nickelschicht stellt eine Diffusionsbarriere bereit. Abschließend wird die Abdeckschicht entfernt. Dies kann insbesondere mittels einer chemischen Lösung ausgeführt werden. Es folgt ein Entfernen der nicht galvanisierten Galvanik-Grundmetallisierung. Dies kann beispielsweise mit einer sauren oder einer basischen Lösung durchgeführt werden.

Gemäß einer weiteren vorteilhaften Ausgestaltung sind die Höhe des mindestens einen Halbleiterchips und die Dicke der ersten Schicht annähernd gleich groß. Auf diese Weise kann auf einfache Weise ein Abstandsbereich zwischen Halbleiterchip und erster Schicht von der zweiten Schicht überbrückt werden.

Gemäß einer weiteren vorteilhaften Ausgestaltung wird unter der zweiten Schicht mindestens ein Surface Mounted Device - Bauteil integriert. Dies ist besonders vorteilhaft bei der Verwendung einer Laminierfolie als zweite Schicht. Diese Folie kann auch über ein benachbartes, kostengünstiges Niederfrequenz-Basissubstrat, zum Beispiel ein Control-Board, ein Fensterausschnitt, das Hochfrequenzsubstrat, laminiert werden. Es können ebenso Übergänge zwischen Niederfrequenz- und Hochfrequenzbereiche eines Substrats beziehungsweise einer Platine im gleichen Prozess hergestellt werden. Die Verfahrenskosten erhöhen sich entsprechend der zusätzlich zu bearbeitenden Substratfläche.

Die vorliegende Erfindung wird anhand von Ausführungsbeispielen in Verbindung mit den Figuren näher beschrieben: Es zeigen
- Figur 1: eine erste elektronische Vorrichtung;
- Figur 2: eine zweite elektronische Vorrichtung;
- Figur 3: eine Draufsicht auf eine dritte elektronische Vorrichtung;
- Figur 4: ein Blockschaltbild eines erfindungsgemäßen Verfahrens.

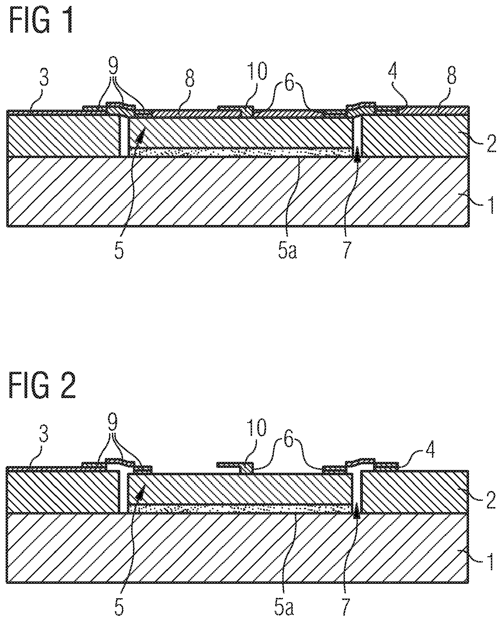

Figur 1 zeigt eine erste elektronische Vorrichtung, die ein gemäß dem erfindungsgemäßen Verfahren hergestelltes Zwischenprodukt darstellt.

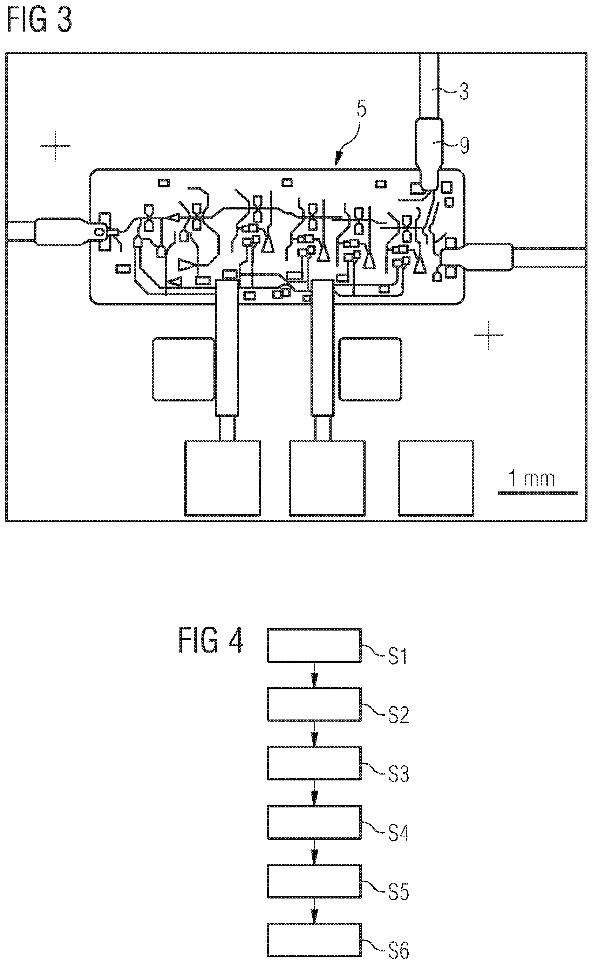

Ein Substrat ist mit dem Bezugszeichen 1 gekennzeichnet. Auf diesem Substrat 1 wurde eine erste Schicht 2 aufgebracht. Die erste Schicht 2 kann eine elektrisch isolierende Folie sein. Auf der ersten Schicht sind elektrische Leitungen 3 mit Kontaktstellen 4 erzeugt. Nach dem Öffnen der ersten Schicht 2 und der Erzeugung eines Fensters ist ein Halbleiterchip (bzw. passives Bauelement) 5 auf dem Substrat 1 fixiert worden. Der Halbleiterchip 5 ist mittels eines Klebstoffs beziehungsweise Adhesivs 5a auf dem Substrat 1 befestigt. Zwischen der ersten Schicht 2 und dem auf dem Klebemittel 5a angeordneten Halbleiterchip 5 ist ein Abstandsbereich 7 beziehungsweise ein Spalt erzeugt. Der Halbleiterchip 5 weist mindestens eine elektrische Kontaktfläche 6 auf. Diese befindet sich auf dem Halbleiterchip 5, auf der dem Substrat 1 abgewandten Seite. Zwischen dem fixierten Halbleiterchip 5 und der erste Schicht 2 ist ein Abstandsbereich 7 beziehungsweise Spalt ausgebildet. Auf dem Halbleiterchip 5, auf der ersten Schicht 2 und über dem Abstandsbereich 7 ist eine zweite Schicht 8 derart angeordnet, dass die Kontaktflächen 6 und die Kontaktstellen 4 frei zugänglich sind. Die zweite Schicht 8 kann eine elektrisch isolierende Folie beispielsweise mit einer Dicke von 20 µm sein. Ebenso kann die zweite Schicht 8 eine fotostrukturierbare Folie oder ein fotostrukturierbarer Lack sein. Zwischen Kontaktflächen 6 des Halbleiterchips 5 und Kontaktstellen 4 der elektrischen Leitungen auf der ersten Schicht 2 sind elektrische Verbindungsleitungen 9 aufgalvanisiert. Figur 1 zeigt ein gemäß einem erfindungsgemäßen Verfahren erzeugtes Zwischenprodukt, wie beispielsweise ein Hochfrequenzmodul. Fig. 3 zeigt ein so genanntes verteiltes elektronisches Bauelement 10. Dieses ist beispielsweise lediglich als Flächenbereich erzeugt, der hochfrequenztechnisch wirkt. Dieses Bauelement liegt auf der zweiten Schicht 8 auf.

Figur 2 zeigt eine gemäß einem Ausführungsbeispiel des erfindungsgemäßen Verfahrens hergestellte elektronische Vorrichtung, insbesondere eines Hochfrequenzmoduls. Gleiche Bezugszeichen zu Fig. 1 zeigen gleiche Bestandteile der elektronischen Vorrichtung. Im Unterschied zu Figur 2 ist die zweite Schicht 8 entfernt worden. Die zweite Schicht 8 kann eine Kunststofffolie sein oder ein Lack. Gemäß dem Ausführungsbeispiel gemäß Figur 1 bildet die zweite Schicht 8 über den Abstandsbereichen 7 einen Träger beziehungsweise eine Brücke für die elektrischen Verbindungsleitungen 9. Die zweite Schicht 8 kann ebenso als elektrische Isolierung verwendet werden. Die zweite Schicht 8 kann über den Abstandsbereichen 7 als Dielektrika angesehen werden. Damit ist der Potentialtrennung zwischen Ober- und Unterseite des Halbleiterchips 5 eine dielektrische Komponente hinzugefügt. Die zweite Schicht 8 wirkt in diesem Bereich als Dielektrika und damit kapazitiv. Damit ist die Potentialtrennung zwischen Ober- und Unterseite des Halbleiterchips 5 verschlechtert. Gemäß Figur 2 ist die zweite Schicht 8 über den Abstandsbereichen 7 entfernt. Damit ist die Potentialtrennung zwischen Ober- und Unterseite des Halbleiterchips 5 verbessert. Gemäß der Vorrichtung gemäß Figur 1 ist die zweite Schicht 8 beibehalten, um einen Verfahrensschritt des Entfernens der zweiten Schicht 8 zu vermeiden. Dies ist kostengünstig. Zudem bewirkt die zweite Schicht 8 eine erhöhte mechanische Stabilität der elektrischen Verbindungsleitungen 9 über den Abstandsbereichen 7. Gemäß der Vorrichtung gemäß Figur 2 wird die Dielektrikaschicht, die durch die zweite Schicht 8 erzeugt wird, und unterhalb der Verbindungsleitung 9 über dem Abstandsbereich 7 angeordnet war, entfernt. Auf diese Weise ist die Potentialtrennung zwischen Ober- und Unterseite des Halbleiterchips 5 gegenüber dem Ausführungsbeispiel gemäß Figur 1 verbessert. Es ist ein weiterer Verfahrensschritt des Entfernens beziehungsweise lokalen Entfernens der zweiten Schicht 8 erforderlich. Im Unterschied zur Figur 2 ist die mechanische Stabilität der Brücken über den Abstandsbereichen 7 in Figur 1 verbessert.

Gemäß Figuren 1 und 2 ist die erste Schicht 2 als Polymerschicht ausgebildet. Ebenso ist der Halbleiterchip 5 ein Chip auf Gallium-Arsenit-(GaAs-), Silizium-Germanium-(SiGe-), Siliziumkarbid-(SiC-) oder Silizium-Basis. Die zweite Schicht 8 ist ebenso als Polymerschicht ausgebildet. Die Verbindungsleitungen 9 sind galvanisch erzeugt.

Figur 3 zeigt eine Draufsicht auf eine elektronische Vorrichtung. Es werden die gleichen Bezugszeichen gemäß Figur 1 und Figur 2 verwendet. Dabei sind die Kontaktflächen 6 des Halbleiterchips 5 mittels elektrischen Verbindungsleitungen 9 mit Kontaktstellen 4 elektronischer Leitungen 3 elektrisch verbunden. Die elektrischen Leitungen 3 können Signalleitungen und/oder elektrische Versorgungsleitungen

Figur 4 zeigt ein Blockdiagramm eines Ausführungsbeispiels des erfindungsgemäßen Verfahrens zur Herstellung und Kontaktieren einer elektronischen Vorrichtung, insbesondere eines Hochfrequenzmoduls. Verfahrensschritt S1 bezeichnet das Aufbringen einer der elektrischen Isolation dienenden ersten Schicht 2 auf einem Substrat 1, wobei auf der ersten Schicht 2 mindestens eine elektrische Leitung 3 mit mindestens einer elektrischen Kontaktstelle 4 erzeugt ist. Verfahrensschritt S2 bezeichnet das Öffnen mindestens eines Fensters für mindestens einen (Halbleiter-)chip 5 in der ersten Schicht 2. Verfahrensschritt S3 bezeichnet das Fixieren des (Halbleiter-)chips 5 innerhalb des Fensters auf dem Substrat 1, wobei auf dem Halbleiterchip 5 mindestens eine elektrische Kontaktfläche 6 und ein Abstandsbereich 7 zwischen Halbleiterchip 5 und erster Schicht 2 erzeugt sind. Verfahrensschritt S4 bezeichnet ein derartiges Anordnen einer zweiten Schicht 8 auf einem Halbleiterchip 5, auf der ersten Schicht 2 und über dem Abstandsbereich 7, dass die Kontaktflächen 6 und die Kontaktstellen 4 frei zugänglich sind. Verfahrensschritt S5 bezeichnet ein galvanisches Abscheiden von elektrisch leitendem Material auf die Kontaktflächen 6 und die Kontaktstellen 4 zum flächigen beziehungsweise planaren elektrischen Kontaktieren auf die zweite Schicht, insbesondere Kunststofffolie zum Erzeugen von elektrischen Verbindungsleitungen 9 zwischen Kontaktflächen 6 und Kontaktstellen 4. Ein elektrisches Kontaktieren von Kontaktflächen 6 und Kontaktstellen 4 kann insbesondere mittels den folgenden Schritten ausgeführt werden: Auflaminieren einer zweiten Schicht 8 aus elektrisch isolierendem Kunststoffmaterial auf die Oberflächen der zweiten Schicht 8, des Halbleiterchips 5 und über Abstandsbereiche 7 unter Vakuum, so dass die zweite Schicht 8, die insbesondere eine Folie ist, die Oberflächen mit der oder den Kontaktflächen 6 beziehungsweise Kontaktstellen 4 eng anliegend bedeckt und auf dieser Oberfläche haftet. Anschließend erfolgt ein Freilegen jeder zu kontaktieren Kontaktfläche 6 und Kontaktstelle 4 auf der Oberfläche durch Öffnen jeweiliger Öffnungen in der zweiten Schicht 8 beziehungsweise der Folie 8. Abschließend werden die freien Kontaktflächen 6 und Kontaktstellen 4 mit einer Schicht aus elektrisch leitendem Material flächig kontaktiert. Auf diese Weise erfolgt ein planares Kontaktieren und es werden elektrische Verbindungsleitungen 9 zwischen Kontaktflächen 6 und Kontaktstellen 4 erzeugt. In diesem Zusammenhang sei erneut auf die WO 03/030247 Bezug genommen, deren Inhalt vollständig zur Offenbarung dieser Anmeldung gehört.

Es schließt sich ein weiterer Verfahrensschritt S6 an. Gemäß diesem Verfahrensschritt S6 wird die zweite Schicht 8 nach dem galvanischen Abscheiden gemäß S5 entweder mittels Laser oder mittels einer chemischer Lösung entfernt. Dabei ist das Entfernen mittels chemischer Lösung, z.B. organischer Lösungsmittel wie Aceton kostengünstig und in kurzer Zeit ausführbar.

Gemäß der vorliegenden Erfindung kann eine Vielzahl von (Halbleiter-)chips 5, elektrischen Kontaktflächen 6, Kontaktstellen 4 und elektrischen Verbindungsleitungen 9 erzeugt sein beziehungsweise werden. Die Anzahl der (Halbleiter-)chips 5 ist ebenso nicht beschränkt. Der Begriff "mindestens" bedeutet eine Einzahl oder eine Mehrzahl von entsprechenden Bestandteilen. Hochfrequenz meint einen Frequenzbereich größer als etwa 200 MHz.

## Patentansprüche

1. Verfahren zum Herstellen und planaren Kontaktieren einer elektronischen Vorrichtung, insbesondere eines Hochfrequenzmoduls, mit den Schritten
- Erzeugen mindestens eines elektronischen Bauelements (5) und Aufbringen einer ersten elektrisch isolierenden Schicht (2) auf einem Substrat (1), wobei das mindestens eine elektronische Bauelement (5) auf dem Substrat (1) und innerhalb mindestens eines Fensters der ersten elektrisch isolierenden Schicht (2) derart angeordnet ist, dass ein Abstandsbereich (7) zwischen dem elektronischen Bauelement (5) und der ersten Schicht (2) erzeugt ist, wobei auf der ersten Schicht (2) mindestens eine elektrische Leitung (3) mit mindestens einer elektrischen Kontaktstelle (4) und auf dem elektronischen Bauelement (5) mindestens eine elektrische Kontaktfläche (6) erzeugt ist,
- derartiges Anordnen einer zweiten elektrisch isolierenden Schicht (8) auf dem elektronischen Bauelement (5), auf der ersten Schicht (2) und über dem Abstandsbereich (7), dass die Kontaktfläche (6) und die Kontaktstelle (4) frei zugänglich sind,
- Aufbringen von einem elektrisch leitenden Material auf die mindestens eine Kontaktfläche (6) und die mindestens eine Kontaktstelle (4) zum flächigen beziehungsweise planaren elektrischen Kontaktieren und auf die zweite Schicht (8) zum Erzeugen mindestens einer elektrischen Verbindungsleitung (9), wobei eine jeweilige Verbindungsleitung (9) über dem Abstandsbereich (7) zwischen einer Kontaktfläche (6) und einer Kontaktstelle (4) derart erzeugt wird, dass mittels der jeweiligen elektrischen Verbindungsleitung (9) die Kontaktfläche (6) und die Kontaktstelle (4) elektrisch verbunden sind, wobei die zweite Schicht (8) entfernt wird.

2. Verfahren nach Anspruch 1,
Hilfsantrag
**dadurch gekennzeichnet, dass**
die zweite Schicht (8) eine Folie aus elektrisch isolierendem Kunststoffmaterial ist, die ganzflächig aufgebracht und über der Kontaktfläche (6) und der Kontaktstelle (4) geöffnet wird.

3. Verfahren nach Anspruch 1,
**dadurch gekennzeichnet, dass**
die zweite Schicht (8) eine fotostrukturierte Schicht ist, die derart aufgebracht wird, dass Kontaktfläche (6) und die Kontaktstelle (4) unbedeckt bleiben.

4. Verfahren nach einem oder mehreren der vorangehenden Ansprüche,
**dadurch gekennzeichnet, dass**
das Aufbringen von elektrisch leitendem Material mittels galvanischem Abscheiden mit folgenden Schritten erfolgt:
- ganzflächiges Aufbringen einer Galvanikgrundmetallisierung auf der zweiten Schicht,
- Aufbringen einer fotostrukturierten Abdeckschicht, wobei von dieser unbedeckte, galvanisierbare Bereiche elektrischen Verbindungsleitungen (9), Kontaktflächen (6) und Kontaktstellen (4) entsprechen,
- Galvanisieren der unbedeckten Bereiche,
- Entfernen der Abdeckschicht,
- Entfernen der nicht galvanisierten Galvanikgrundmetallisierung.

5. Verfahren nach einem oder mehreren der vorangehenden Ansprüche 1 bis 4,
**dadurch gekennzeichnet, dass**
die Höhe des elektronischen Bauelements (5) und die Dicke der ersten Schicht (2) annähernd gleich groß sind.

6. Verfahren nach einem oder mehreren der vorangehenden Ansprüche 1 bis 5,
**dadurch gekennzeichnet, dass**
unter der zweiten Schicht (8) mindestens ein surface mounted device (SMD) -Bauteil integriert wird.

7. Verfahren nach einem oder mehreren der vorangehenden Ansprüche 1 bis 6,
**dadurch gekennzeichnet, dass** das Erzeugen des elektronischen Bauelements (5) auf dem Substrat (1) die Schritte umfasst:
- Öffnen des mindestens einen Fensters für das mindestens eine elektronische Bauelement (5), insbesondere einen Halbleiterchip, in der ersten Schicht (2),
- Fixieren des elektronischen Bauelements (5) innerhalb des Fensters auf dem Substrat (1).

## Claims

1. Method for production and planar contacting of an electronic apparatus, in particular a high frequency module, with the steps of
- generating at least one electronic component (5) and applying a first electrically insulating layer (2) to a substrate (1), wherein the at least one electronic component (5) is arranged on the substrate (1) and within at least one window of the first electrically insulating layer (2) in such a way that a gap area (7) between the electronic component (5) and the first layer (2) is generated, wherein at least one electrical line (3) with at least one electrical contacting point (4) is generated on the first layer (2) and at least one electrical contacting area (6) is generated on the electronic component (5),
- arranging a second electrically insulating layer (8) on the electronic component (5), on the first layer (2) and over the gap area (7), in such a way that the contacting point (6) and contacting area (4) are freely accessible,
- applying an electrically conducting material to the at least one contacting area (6) and the at least one contacting point (4) for flat or planar electrical contacting, and to the second layer (8) to generate at least one electrical connecting line, wherein a respective connecting line (9) is generated over the gap area (7) between a contacting area (6) and a contacting point (4), such that by means of the respective electrical connecting line (9) the contacting area (6) and the contacting point (4) are electrically connected, wherein the second layer (8) is removed.

2. Method according to claim 1, **characterised in that** the second layer (8) is a film of electrically insulating plastic material, which is applied over the whole area and opened over the contacting area (6) and contacting point (4).

3. Method according to claim 1, **characterised in that** the second layer (8) is a photostructured layer, which is applied so that the contacting area (6) and contacting point (4) remain uncovered.

4. Method according to one or more of the preceding claims, **characterised in that** electrically conducting material is applied by means of galvanic deposition, with the following steps:
- applying a galvanic substrate metallisation to the whole area of the second layer,
- applying a photostructured covering layer, electroplatable areas which are not covered by it corresponding to connecting lines (9), contacting areas (6) and contacting points (4),
- electroplating the uncovered areas,
- removing the covering layer,
- removing the galvanic substrate metallisation which has not been electroplated.

5. Method according to one or more of the preceding claims 1 to 4, **characterised in that** the height of the electronic component (5) and the thickness of the first layer (2) are approximately equal.

6. Method according to one or more of the preceding claims 1 to 5, **characterised in that** under the second layer (8) at least one surface mounted device (SMD) component is integrated.

7. Method according to one or more of the preceding claims 1 to 6, **characterised in that** the generation of the electronic component (5) on the substrate (1) includes the steps of:
- opening the at least one window for the at least one electronic component (5), in particular a semiconductor chip, in the first layer (2),
- fixing the electronic component (5) within the window on the substrate (1).

## Revendications

1. Procédé de fabrication et de mise en contact planaire d'un dispositif électronique, en particulier d'un module à haute fréquence, comprenant les étapes
- de production d'au moins un composant électronique (5) et d'application d'une première couche (2) isolante électriquement sur un substrat (1), dans lequel l'au moins un composant électronique (5) est ainsi agencé sur le substrat (1) et à l'intérieur d'au moins une fenêtre de la première couche (2) isolante électriquement qu'une partie d'espacement (7) est produite entre le composant électronique (5) et la première couche (2), dans lequel au moins une ligne électrique (3) comprenant au moins un point de contact (4) électrique est produite sur la première couche (2) et au moins une surface de contact (6) électrique est produite sur le composant électronique (5),
- d'agencement tel d'une deuxième couche (8) isolante électriquement sur le composant électronique (5), sur la première couche (2) et au-dessus de la partie d'espacement (7), que la surface de contact (6) et le point de contact (4) sont accessibles librement,
- d'application d'un matériau conducteur électrique sur l'au moins une surface de contact (6) et l'au moins un point de contact (4) pour la mise en contact électrique planaire, respectivement plate, et sur la deuxième couche (8) pour produire au moins une ligne électrique de liaison (9), dans lequel une ligne de liaison (9) respective au-dessus de la partie d'espacement (7) est ainsi produite entre une surface de contact (6) et un point de contact (4) qu'au moyen de la ligne électrique de liaison (9) respective, la surface de contact (6) et le point de contact (4) sont reliés électriquement, dans lequel la deuxième couche (8) est enlevée.

2. Procédé selon la revendication 1,
**caractérisé en ce que**
la deuxième couche (8) est un film de matériau plastique isolant électriquement qui est appliqué sur toute la surface et est ouvert au-dessus de la surface de contact (6) et du point de contact (4).

3. Procédé selon la revendication 1,
**caractérisé en ce que**
la deuxième couche (8) est une couche photostructurée qui est ainsi appliquée que la surface de contact (6) et le point de contact (4) restent découverts.

4. Procédé selon l'une ou plusieurs des revendications précédentes,
**caractérisé en ce que**
l'application de matériau isolant électriquement est effectuée par isolation galvanique avec les étapes suivantes :
- application sur toute la surface d'une métallisation de base galvanique sur la deuxième couche,
- application d'une couche de recouvrement photostructurée, dans lequel des zones découvertes pouvant être galvanisées de celle-ci correspondent à des lignes de liaison (9) électriques, des surfaces de contact (6) et des points de contact (4),
- galvanisation des parties découvertes,
- enlèvement de la couche de recouvrement,
- enlèvement de la métallisation de base galvanique non galvanisée.

5. Procédé selon l'une ou plusieurs des revendications précédentes 1 à 4,
**caractérisé en ce que**
la hauteur du composant électronique (5) et l'épaisseur de la première couche (2) sont presque aussi grandes.

6. Procédé selon l'une ou plusieurs des revendications précédentes 1 à 5,
**caractérisé en ce**
**qu'**au moins un composant monté en surface (SMD) est intégré sous la deuxième couche (8).

7. Procédé selon l'une ou plusieurs des revendications précédentes 1 à 6,
**caractérisé en ce que** la production du composant électronique (5) sur le substrat (1) comprend les étapes suivantes :
- ouverture de l'au moins une fenêtre pour l'au moins un composant électronique (5), en particulier une puce semiconductrice, dans la première couche (2),
- fixation du composant électronique (5) à l'intérieur de la fenêtre sur le substrat (1).
